## Europäisches Patentamt
## European Patent Office
## Office européen des brevets

(19)

(11) Veröffentlichungsnummer: **0 076 455**
**B1**

(12)

# EUROPÄISCHE PATENTSCHRIFT

(45) Veröffentlichungstag der Patentschrift:
**29.04.87**

(51) Int. Cl.⁴: **F 24 J 2/42,** H 01 L 31/00, H 01 L 25/04

(21) Anmeldenummer: **82108955.4**

(22) Anmeldetag: **28.09.82**

(54) **Solarkraftwerk.**

(30) Priorität: **01.10.81 DE 8128670 U**
**03.11.81 DE 3143458**

(43) Veröffentlichungstag der Anmeldung:
**13.04.83 Patentblatt 83/15**

(45) Bekanntmachung des Hinweises auf die Patenterteilung:
**29.04.87 Patentblatt 87/18**

(84) Benannte Vertragsstaaten:
**AT CH DE FR IT LI**

(73) Patentinhaber: **Wenzel, Joachim, Hauptmannsreute 46, D-7000 Stuttgart 1 (DE)**

(72) Erfinder: **Wenzel, Joachim, Hauptmannsreute 46, D-7000 Stuttgart 1 (DE)**

(56) Entgegenhaltungen:
**EP-A-0 028 982**
**EP-A-0 036 323**
**FR-A-2 376 378**
**FR-A-2 420 099**
**US-A-4 102 324**
**US-A-4 265 422**

**EHRENKRANZ GROUP: "Active solar energy system design practice mannal, 1979, Mueller Associates, Baltimore, USA**

EP 0 076 455 B1

## Beschreibung

Die Erfindung betrifft ein Solarkraftwerk mit ebenflächigen Elementen zur Aufnahme von Solarkollektoren oder von mit Solarzellen kombinierten Kollektoren oder von Sollarzellen für sich allein mit einem Gestell mit horizontalen Trägern, welches an lotrechten Stützen befestigt ist.

Es ist bereits eine Wärme- Kollektoranlage mit diesen Merkmalen bekannt, die zur Versorgung von Wohnhäusern mit Brauchwasser, Schwimmbecken oder dergleichen dient. Dabei dienen die horizontalen Träger dazu, eine Kinderschaukel oder Turngeräte anzubringen, so daß das Gestell gleichzeitig für diese Geräte genutzt wird, die zumeist auf einem Kinderspielplatz oder in einem Garten angeordnet sind, der auf dem Grundstück eines Ein- oder Mehrfamilienhauses liegt. Deshalb handelt es sich hier nur um verhältnismäßig kleine Anlagen für den häuslichen Gebrauch (USA-PS-4102324).

Bei größeren Anlagen sind jedoch die Flächen auch auf den Dächern der Gebäude nicht ausreichend, um entweder die erforderlichen Wärmekollektoren oder Solarmodule zu installieren. Das gilt zum Beispiel auch von größeren öffentlichen Schwimmbädern, bei denen die Dachfläche der Umkleidekabinen meistens nicht ausreichend ist, die Wärmekollektoren in herkömmlicher Anordnung aufzunehmen. Dies gilt weiter von großen mehrstöckigen Sommer- Hotels, deren Dachfläche nicht ausreichend ist, das Brauchwasser und die Badebecken zu erwärmen, selbst wenn man das gesamte Flachdach in herkömmlicher Weise mit einem Kollektorfeld belegt, bei denen die Kollektoren in der Regel auf gleicher Höhe angeordnet sind. Aber auch da, wo man die jeweils nächstfolgende der Sonne abgewandte Reihe auf höhere Stützen als die vorangegangene angeordnet hat, ist der Flächenbedarf nur wenig gemindert. Außerdem ist der Aufwand für ein derartiges Gestell infolge der Vielzahl der Stützen sehr groß.

Ganz allgemein ist die Solarenergie daher mit dem schweren Problem belastet, daß der Bodenflächenbedarf sehr groß ist. Dies liegt unter anderem auch daran, daß die Kollektoren in möglichst großer Nähe des Verbrauchers angeordnet sein müssen, weil sonst die Leitungen zu lang und damit zu aufwendig werden.

Der Erfindung liegt die Aufgabe zugrunde, das erwähnte Problem des Flächenbedarfs zu lösen.

Zur Lösung dieser Aufgabe ist vorgesehen, daß mehrere Elemente in Abständen senkrecht übereinander angeordnet sind und daß die Abstände zum Boden und jeder Abstand zwischen den Elementen so groß ist, daß die Sonneneinstrahlung den Boden hinter den Elementen erreicht und eine wesentliche gegenseitige Beschattung der Elemente während des ganzen Jahres nicht eintritt, und daß zwischen den horizontalen Trägern und den Elementen diese stützende Streben angeordnet sind.

Dadurch kann der Boden nördlich des Solarkraftwerkes für beliebige Zwecke genutzt werden, unter anderem auch für die Landwirtschaft, weil genügende Sonneneinstrahlung den Boden hinter den Elementen erreicht.

Ein weiterer großer Vorteil besteht darin, daß sich die Elemente gegenseitig während des ganzen Jahres nicht beschatten.

Der Flächenbedarf ist so gering, daß in allen Fällen möglich ist, den Erfindungsgegenstand zusätzlich zu einer bereits vorhandenen Anlage anzuordnen.

Weitere Vorteile, Ziele und Einzelheiten der Erfindung ergeben sich aus der nun folgenden Beschreibung einiger Ausführungsbeispiele unter Hinweis auf die Zeichnung. In dieser zeigen:

Fig. 1 eine Seitenansicht auf den Erfindungsgegenstand, der an einem bekannten Speicherbehälter angeordnet ist;

Fig. 2 eine Draufsicht auf die Darstellung nach Fig. 1;

Fig. 3 eine Seitenansicht von der Nordseite auf die Ausführungsform nach den vorangegangenen Figuren;

Fig. 4 einen Teilschnitt quer zur Längsrichtung durch den obersten Teil einer stark vergrößerten weiteren Ausführungsform und

Fig. 5 eine Seitenansicht auf den oberen Teil einer weiteren Ausführungsform.

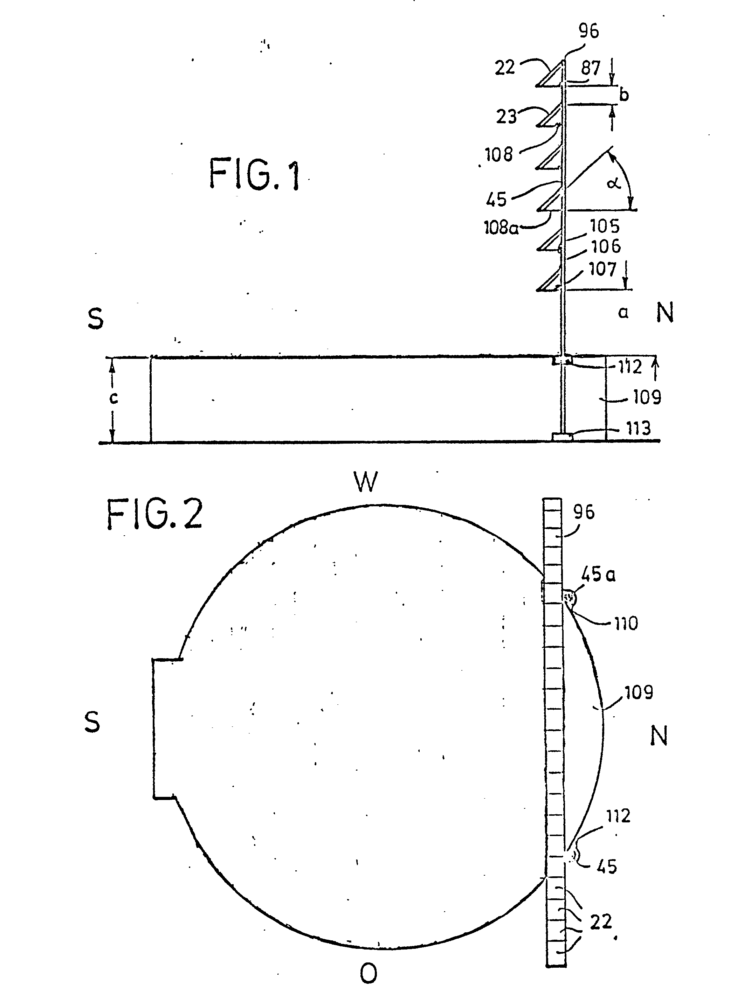

In Fig. 1 sieht man unten den Speicherbehälter 109 bekannter Bauart mit einer Höhe c über dem Boden von zum Beispiel 7 m. Der Behälter kann jedoch teilweise oder sogar vollständig in dem Erdboden versenkt angeordnet sein.

An der Südseite der Masten sind horizontale starre Träger 96 - 107 befestigt, an denen die Kollektoren 22, 23 wie folgt angebracht sind:

An dem unteren Träger sind die Elemente stützende Streben 108, 108a, angebracht, die etwa horizontal liegen und an der Unterkante der Elemente angreifen. Die Oberkante ist an dem darüber liegenden Träger direkt befestigt, so daß sich der Winkel $\alpha$ ergibt. Durch eine Veränderung der Länge der abstandshaltenden Streben 108 a läßt sich der Winkel $\alpha$ ändern.

Der Abstand a zwischen der Oberkante des Behälters 109 und der Unterkante der unterst ordneten Kollektorenreihe wird ebenso wie der Abstand b zwischen zwei Kollektorreihen so gewählt, daß eine wesentliche gegenseitige Beschattung während des ganzen Jahres nicht eintritt. Man kennt den maximalen Einstrahlungswinkel im Sommer, so daß diese Abstände so gewählt werden können, daß in unseren Breitengraden praktisch überhaupt gar keine gegenseitige Beschattung eintritt.

In Fig. 2 sieht man die beiden lotrechten Stützen 45, 45a, an denen die Kollektorreihen, wie in Fig. 1 dargestellt, angebracht sind.

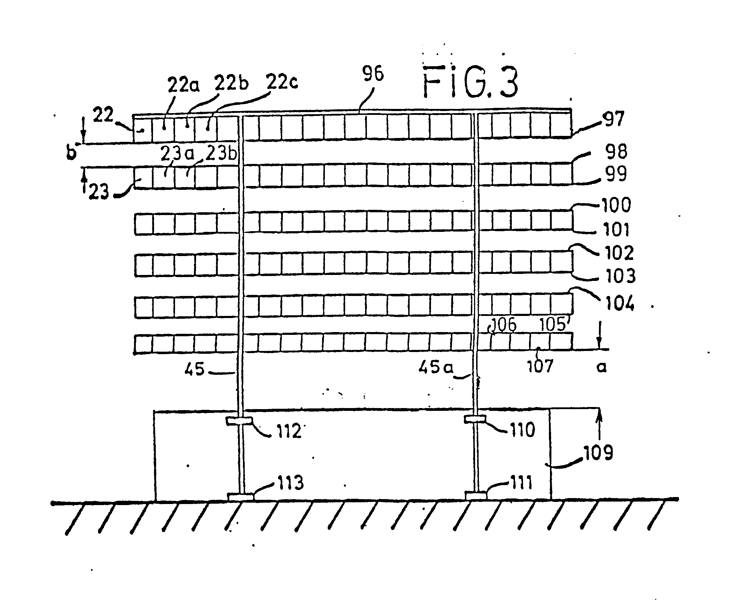

Fig. 3 zeigt ebenso wie Fig. 2, daß die Länge der erwähnten horizontalen Träger 96 - 107 zur Anbringung der Kollektoren 22, 23 sehr viel größer ist als der Abstand zwischen den beiden Masten 45, 45a. Sie sind sogar größer gehalten als der Durchmesser des Behälters 109 und daher im vorliegenden Falle länger als 100 m. Bei dieser Größe könnte daher auch zweckmäßig sein, weitere Masten 45 anzuordnen. Ferner könnten die Masten zusätzlich mit Spannseilen, wie bekannt, mit dem Boden oder dem Behälter verspannt sein. Diese Seile sind sehr dünn, so daß die hierdurch hervorgerufene Beschattung unbedeutend ist.

Die Kollektoren 22, 23 überragen den Behälter erheblich, wodurch aber keinesfalls eine zusätzliche Bodenfläche in Anspruch genommen wird, weil die unterste Kollektorreihe um einen Abstand über dem Boden liegt, der gleich ist a plus c. Bei dieser Höhe der Anordnung wird die Bodenflächennutzung, zum Beispiel durch Landwirtschaft, nicht gestört. Dagegen ist nicht zu vermeiden, daß ein gewisser zusätzlicher Schatten in den Bereich nördlich des Behälters und morgens und abends auch östlich und westlich hiervon fällt. Die Landwirtschaft wird dadurch aber nicht behindert. Zum einen wandert der Schatten sehr schnell, zum anderen ist bekanntlich auch im Schatten nördlich des Solarkraftwerkes eine gewisse Sonnenbeeinflussung vorhanden, weil die Streustrahlung den Boden unbehindert erreicht.

Natürlich muß die erfindungsgemäße Anlage auch sturmsicher sein. Hier erweist sich als vorteilhaft, das infolge der Abstände a und b zwischen den einzelnen Reihen der Kollektoren der Wind keine große Angriffsfläche findet. Dennoch könnte sich die erwähnte Abspannung mit Seilen zum Boden oder zum Behälter nicht nur der beiden Masten 45, 45a, sondern auch der Träger 96-107 als zweckmäßig erweisen. Fig. 3 zeigt, daß jeder Mast 45, 45a mit je zwei Rohrschellen 110, 112 oben und 111, 113 unten versehen ist. Diese können an den Masten angeschweißt sein und werden dann flanschartig mit dem Behälter 109 verschraubt.

Ganz allgemein können die Masten so hoch sein, daß sie die benötigte Anzahl von Kollektorreihen aufnehmen. Eine solche Ausgestaltung ist natürlich auch für die Anordnung von Solarzellen zur Erzeugung von elektrischer Energie allein geeignet. Entscheidend ist auch hier der der Erfindung zugrunde liegende Gedanke, daß die senkrechte Dimension ausgenützt werden kann, um eine wesentlich grössere Anzahl von Kollektoren oder Solarzellen unterzubringen, ohne daß irgendein zusätzlicher Bodenflächenbedarf entsteht.

Bei der dargestellten Ausführungsform sind ferner die erforderlichen Wärmemitteleitungen, falls es sich um Wärmekollektoren handelt, nicht eingezeichnet.

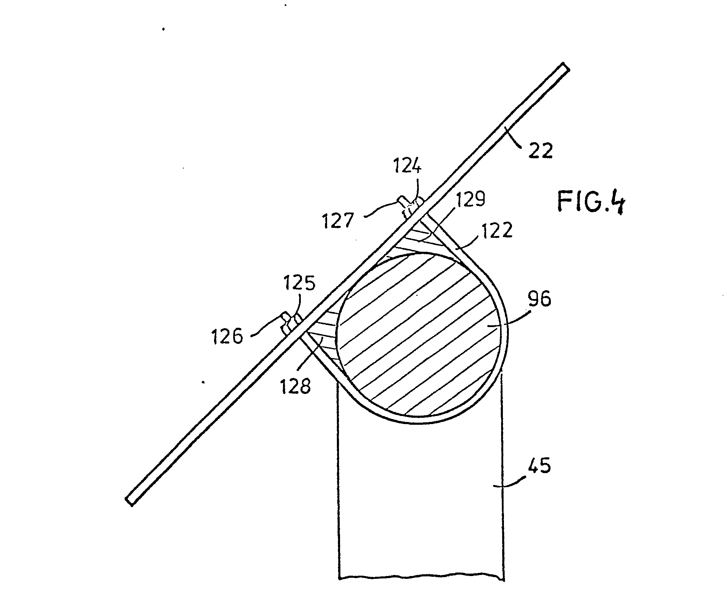

· Fig. 4 zeigt eine weitere Ausführungsform mit dem obersten horizontalen Querträger 96 nach den Fig. 1-3. Das Element 22 ist hier in der Mitte desselben auf den Querträger 96 aufgelegt und mit dem Rundstahl 123 und den beiden Schrauben 124 und 125 festgeklemmt. Hierzu sind die beiden Enden der Rundstähle mit Gewinden 126, 127 versehen, auf die die Muttern 124, 125 aufgeschraubt sind. Diese Enden sind durch nicht dargestellte Löcher in den Rahmen des Elementes 22 gesteckt. Damit die linienförmige Berührung und Beanspruchung vermieden ist, sind noch zwei Abstandsklötze 128, 129 in den Ecken zwischen den Elementen 22 und dem Träger 96 vorgesehen. An der nicht dargestellten gegenüberliegenden Seite des Rahmens ist eine genau gleiche dahinter liegende Befestigungsvorrichtung angeordnet. Durch diese beiden Rundstähle 123 mit den vier Muttern ist somit das Kollektorelement 22 vollständig und ausreichend befestigt. Nur für den Fall, daß das Element eine sehr große axiale Länge haben sollte, könnte ein weiteres ähnliches Befestigungselement vorgesehen sein, das dann einesteils an der Rückwand des Kollektorelementes angeschweißt sein könnte. Nur einmal ist eine Verschraubung wirklich nötig.

Diese Ausführung ist nur bei dem obersten Querträger 96 zweckmäßig. Bei den anderen weniger, weil dann eine Beschattung durch die Masten 45 teilweise eintreten würde.

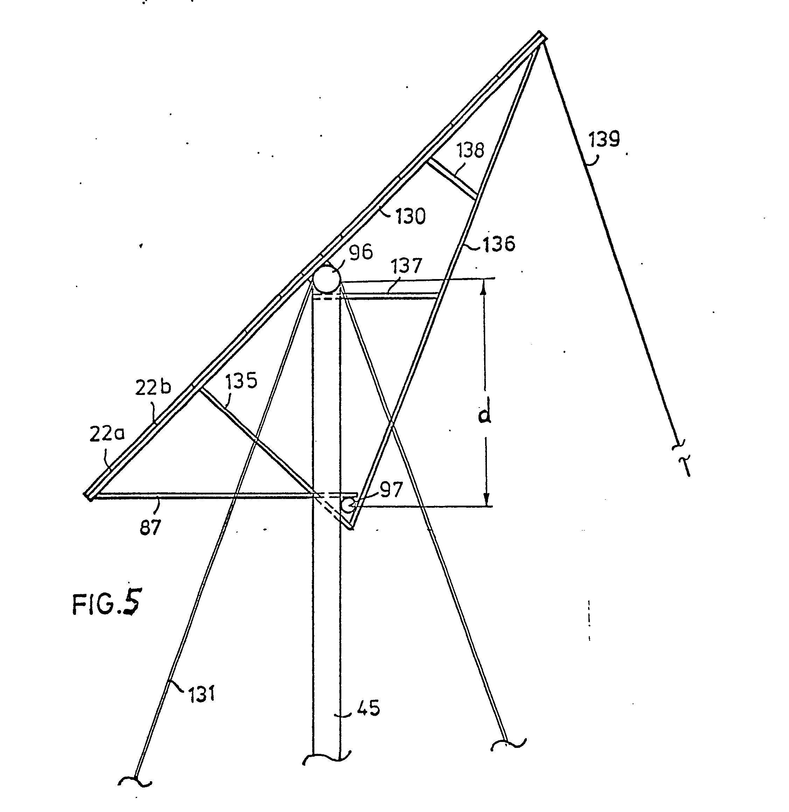

Fig. 5 zeigt ebenfalls nur den obersten Teil der Anlage, jedoch bei einer größeren Ausführungsform. Deshalb sind hier eine größere Anzahl von Elementen 22a, 22b angeordnet, so daß ein zusätzlicher Träger 130 unter den Elementen anzubringen ist. Über die axiale Länge sind natürlich mehrere derartige Träger vorhanden.

Ferner ist hier ein zweiter horizontaler Träger 97 unten an der gleichen Stütze 45 im Abstand d von dem obersten Querträger 96 befestigt. Dieser dient im vorliegenden Falle dazu, die zusätzlichen Elemente durch die Streben 135-138 abzustützen. Hierzu ist die Strebe 135 senkrecht zu den Elementen bzw. dem Träger 130 angeordnet und greift an diesem an. Dadurch ergibt sich zwangsläufig der Abstand d. Die Strebe 87 verläuft horizontal von dem Träger 97 zu der Unterkante der Elemente. Die Konstruktion auf der rechten Seite des Mastes 45 ist demgegenüber anders. Die Strebe 136 verläuft von dem Querträger 97 zu dem obersten Ende der Elemente. Hierzu ist eine weitere Strebe 137 sehr zweckmäßig, die vom Träger 96 zu der Strebe 136 führt. Ferner ist oben eine Strebe 138 zwischen der Strebe 136 und dem Träger 130 vorgesehen. Auf diese Weise ist der Träger 130 etwa in gleichen Abständen durch die Streben 135-138 abgestützt, die die Windkraft oder auch die Schneelast im Winter über die beiden Träger 96, 97 auf den Mast 45 übertragen.

Zur weiteren Sicherung können die beiden Seile 131 und 139 vorgesehen sein.

Die erfindungsgemäße Konstruktion zeigt insgesamt den Vorteil, daß die Zahl der Stützen und Streben im Vergleich zu herkömmlichen Ausführungen gering ist, ebenso die Zahl der horizontalen Träger.

Es ist richtig, daß bei hohen Anlagen die Zugänglichkeit der Kollektorelemente 22 weniger leicht ist. Die über viele Jahre sich erstreckende Erfahrung hat aber gelehrt, daß Kollektorelemente jahrelang ohne Wartung arbeiten können. Das liegt sehr wahrscheinlich daran, daß der anfallende Schmutz regelmäßig durch Regen beseitigt und somit die Anlage automatisch gereinigt wird.

Die Stützen oder Masten 45, 45a können bis zu einer gewissen Höhe der horizontalen Träger 96, 97 usw. aus imprägniertem Holz bestehen. Die übrigen Teile könnten aus rostgeschütztem Stahl gefertigt sein. Ab einer gewissen Größe kann die ganze Anlage auch aus Stahl bestehen, ferner können die Masten 45 auch aus Schleudergußbeton gefertigt sein.

Der Aufwand ist gegenüber dem Stand der Technik verringert, weil die Zahl der Teile wesentlich verringert ist. Eine Bearbeitung der Holzteile ist kaum nötig, es genügt grobes Schälen der Stangen. Die Befestigung erfolgt mittels weniger Bolzen.

Entscheidend ist aber, daß der Bodenflächenbedarf nahezu gleich Null sein kann und die Sonnenstrahlung den Boden erreicht. Infolge der Beschattung tritt in warmen Ländern die Umweltverbesserung ein, daß der Boden nicht so schnell austrocknet, so daß die Landwirtschaft verbessert wird.

## Patentansprüche

1. Solarkraftwerk mit ebenflächigen Elementen zur Aufnahme von Solarkollektoren oder von mit Solarzellen kombinierten Kollektoren oder von Solarzellen für sich allein mit einem Gestell mit horizontalen Trägern (96-107), welches an lotrechten Stützen (45, 45a) befestigt ist, dadurch gekennzeichnet, daß mehrere Elemente (22, 23) in Abständen (b) senkrecht übereinander angeordnet sind und daß der Abstand zum Boden und jeder Abstnd zwischen den Elementen so groß ist, daß die Sonneneinstrahlung den Boden hinter den Elementen erreicht und eine wesentliche gegenseitige Beschattung der Elemente während des ganzen Jahres nicht eintritt, und daß zwischen den horizontalen Trägern (96-107) und den Elementen (22, 22a, 22b, 23) diese stützende Streben (87, 105-108, 108a, 135-138) angeordnet sind.

2. Solarkraftwerk nach Anspruch 1, dadurch gekennzeichnet, daß die Elemente (22, 22a, 22b, 22c) auf dem obersten horizontalen Träger (96) in der Seitenansicht etwa mittig aufliegen und mit Rund- oder Flachstählen (123) an dem Träger (96) angeklemmt sind, die den Träger umschlingen und mit den Elementen verschraubt sind.

## Claims

1. Solar power station with flat elements for receiving solar collectors or collectors combined with solar cells, or solar cells alone, with a frame means having horizontal carriers (96-107), fixed to vertical supports (45, 45a), characterized in that several elements (22, 23) are arranged in vertically superimposed manner at distances (b) and that the distance from the ground and each distance between the elements is sufficiently large that the solar radiation reaches the ground behind the elements and there is no significant reciprocal shading of the elements throughout the year and that between the horizontal carriers (96-107) and the elements (23, 22a, 22b, 23) are arranged struts (87, 105-108, 108a, 135-138) supporting the same.

2. Solar power station according to claim 1, characterized in that the elements (22, 22a, 22b, 22c) engage roughly centrally in side view on the top horizontal carrier (96) and are secured to the latter with flat or round steel bars (123), which embrace the carriers and are screwed to the elements.

## Revendications

1°) Centrale solaire à éléments de même surface pour recevoir des collecteurs solaires ou des collecteurs combinés à des cellules solaires ou de cellules solaires seules, avec un châssis à traverses horizontales (96-107) qui est fixé à des montants verticaux (45, 45a), caractérisée en ce que plusieurs éléments (22, 23) sont prévus verticalement les uns au-dessus des autres à des distances (b) et en ce que la distance au sol et chaque distance entre les éléments sont choisies de manière que le rayonnement solaire incident arrive sur le sol derrière les éléments et qu'il n'y ait pas d'ombre portée réciproque des éléments pendant toute l'année, et en ce qu'entre les traverses horizontales (96-107) et les éléments (22, 22a, 22b, 23) il y a des entretoises d'appui (87, 105-108, 108a, 135-138).

2°) Centrale solaire selon la revendication 1, caractérisée en ce que les éléments (22, 22a, 22b, 22c) s'appuient sur la traverse horizontale supérieure (96) sensiblement au milieu en vue de côté et sont pincés par des fers ronds ou des fers plats (123) sur la traverse (96), ces fers entourant la traverse et étant vissés aux éléments.

# FIG.1

96

22
87
b

23

108

α

45

108a

105
106
107

S
a
N

112
c
109
113

# FIG.2

W

96

45a

110

S

109

N

112

45

22

O

FIG.3

FIG.4

FIG.5